# EUROPEAN PATENT SPECIFICATION

(11) **EP 1 355 360 B1**
(45) Date of publication and mention of the grant of the patent: **15.11.2006**
(21) Application number: 02252751.9
(22) Date of filing: 18.04.2002
(51) Int. Cl.: H01L 27/146

(54) **Semiconductor structure**
Halbleiterstruktur
Structure à semi-conducteur

(43) Date of publication of application: 22.10.2003
(73) Proprietor: STMicroelectronics Limited, Marlow, Buckinghamshire SL7 1YL (GB)
(72) Inventor: Raynor, Jeff, Edinburgh, EH12 5BD (GB)
(74) Representative: Cooper, John

(56) References cited:
- EP-A- 0 631 327
- US-A- 5 861 655
- US-A- 5 898 196
- US-A- 6 084 259
- PATENT ABSTRACTS OF JAPAN vol. 011, no. 119 (E-499), 14 April 1987 (1987-04-14) -& JP 61 265866 A (SHARP CORP), 25 November 1986 (1986-11-25)

## Description

This invention relates to a solid state image sensing structure.

It is well known to use CMOS, active pixel image sensors in which incident light generates electrons which are captured by a photodiode in the pixel. Where a high speed image sensor is desired, there is less time available for capturing light. One way to address this problem is to increase the illumination level but this is frequently impracticable or undesirable.

Another approach is to use large pixels, as more photons impinge on a large pixel than a small pixel (given the same field of view and depth of field). However, in the prior art large pixels have a large photodiode and the capacitance of the photodiode is also increased. These photodiodes are usually operated in voltage mode, and since V=Q/C as the capacitance rises the voltage falls.
What is required is a large area pixel, but a small sensing capacitance. US 5,471,515 describes one approach to this requirement, by putting a thin layer "photogate" over the light collecting part of the pixel. By applying a voltage to the photogate, the electrons are "pushed" through the transfer gate and into the sense node. However, there are practical disadvantages using this technique with large pixels. One is that a large area of photogate is difficult to manufacture with high yields.

Another is that pushing the electrons over a large area into the transfer gate (charge transfer efficiency) is also difficult to achieve. These problems may be addressed by modifying the manufacturing process, but this is not desirable as silicon fabrication costs rely on mass producing devices using a standard process.

US 5,861,655 discloses a solid state image sensing structure, where semiconductor regions forming photodiodes are spaced from the active elements of a pixel structure within a substrate which can in one embodiment be a silicon substrate epitaxially grown on a wafer.

Other solid state image sensing structures which are in a similar technical field are disclosed in EP 0,631,327; US 5,898,196 and US 6,084,259.

The present invention is defined in claim 1.

Other features and advantages of the invention will be apparent from the remaining claims and the following description.

Embodiments of the invention will now be described, by way of example only, with reference to the drawings, in which:
Figure 1 is a schematic cross-sectional view of one pixel of a prior art image sensor having a large area pixel and large area photodiode;
Figure 2 is a similar view of a prior art sensor having a large area pixel and small photodiode;
Figure 3 is a similar view of a further image sensor; and
Figure 4 shows an embodiment of the invention.

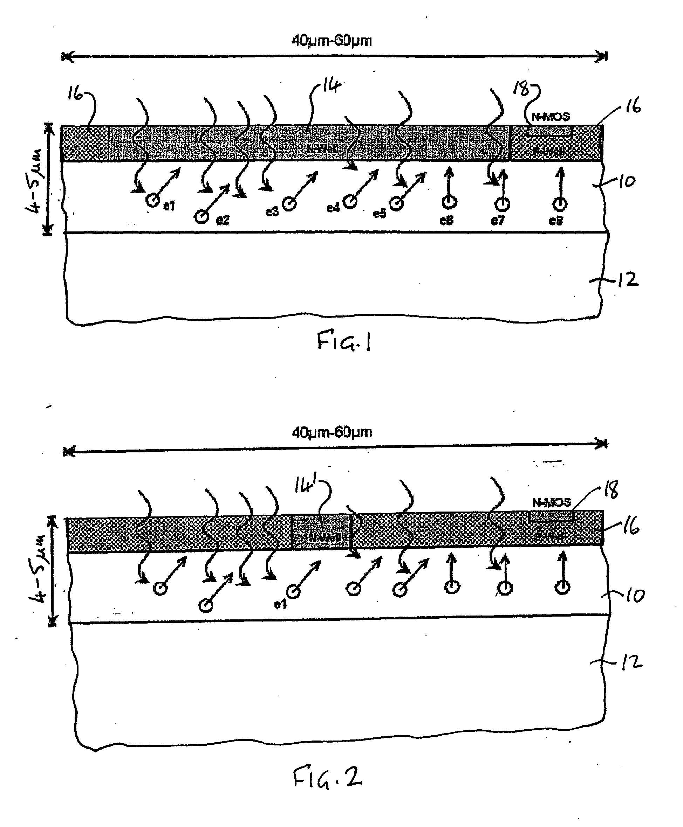

Figure 1 shows the pixel layout of one known sensor. The pixel is "large" in that it has a width of typically 40-60 microns, as opposed to applications such as television which typically have a pixel dimension of 4-6 microns. The pixel is formed in a P-epitaxial layer 10 having a thickness of 4-5 microns, the Pepitaxial layer being on a P substrate 12. The photodiode comprises an N-well 14, and is surrounded by a P-well 16 containing readout circuitry such as the NMOS transistor 18.

In the example of Figure 1, the photodiode 14 is large, in that it occupies most of the surface of the pixel. This leads to a high collection efficiency: electrons e1-e7 are collected by the photodiode, while electron e8 goes to the P-well 16, which is connected to the supply, and is lost. However, the capacitance of the photodiode 14 is high.

In Figure 2, a pixel of the same size and general structure has a photodiode N-well 14' of small size and thus of low capacitance. However, the collection efficiency is low: electron e1 is collected by the photodiode 14, but all other electrons go to the P-well 16 and are lost.

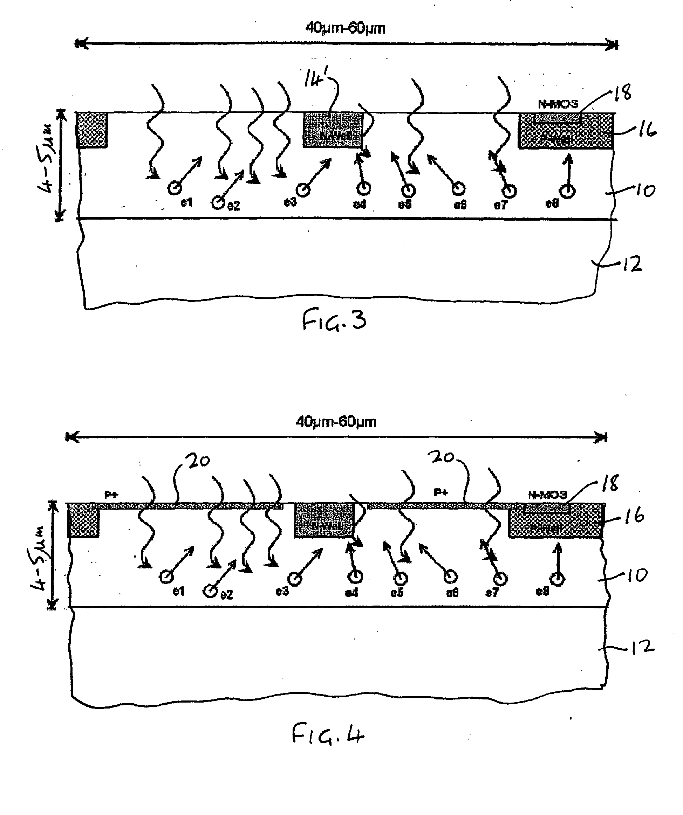

Figure 3 shows a basic form of a further image sensor. The circuit is formed, as before, with a P-epitaxial layer 10 on a P substrate 12, and with a pixel dimension typically 40-60 microns and 4-5 microns depth of the epitaxial layer 10.

A photodiode is provided by N-well 14' of small size, and pixel circuitry is located within P-well 16. However, the P-well 16 is spaced away from the N-well 14', such that the N-well 14' is surrounded by epitaxial material.

Owing to the absence of P material in the vicinity, the majority of electrons, such as e1-e6 in Figure 3, will diffuse in the epitaxial layer 10and ultimately be collected by the N-well 14'. Electron e7 may find its way either to the N-well 14' or to the P-well 16. Electron e8 will most likely find its way to the P-well 16 and be lost.

This effect occurs because the P-epitaxial layer is very lightly doped and not connected to ground. Photogenerated electrons move at random by thermal diffusion until they are attracted by the positively-charged N-well 14' and are detected.

To maximise this effect, the epitaxial layer should be such that incident photons generate electrons within this layer. This process is wavelength dependent, longer wavelengths penetrating deeper into the semiconductor. An epitaxial layer 4-5 microns thick is sufficient to collect light in the visible part of the spectrum. If infrared light is to be collected, the epitaxial layer should be made thicker, e.g. 10 microns.

For a pixel of the size range shown, a photodiode size of 3-10 microns is practical. The lower figure provides the higher sensitivity, but is constrained by manufacturing tolerances and also its ability to store photons. If too few photons are stored, the photon shot noise is increased and hence the ultimate signal-noise ration of the sensor is degraded.

Thus the arrangement of Figure 3 combines a low photodiode capacitance with a high collection efficiency. The necessary change of structure in comparison with the prior art does not require any change in the manufacturing process and thus permits low cost fabrication; it may require modification to the mask preparation stage, but this is only a one-off cost.

N-well is preferred for use as the photodiode collection node, as it penetrates deeper into the epitaxial layer and hence is more efficient in collecting electrons. However, in principle the conductivity types could be inverted, and a P-well used in a N-epitaxial layer on a N substrate.

The use of a small photodiode with a large pixel size cannot be extended indefinitely. With larger areas, the electrons will recombine with hole defects in the silicon before being captured, and will be lost. The mean distance over which the electron will travel before recombination is known as the "recombination length", and in modern silicon substrates is typically about 50 microns. Thus a pixel size of about 60 microns is a practical upper limit with present silicon technology.

Figure 4 shows an embodiment of the invention. A thin layer 20 of P+ material is placed over the majority of the pixel. The layer 20 extends into the P-well 16 and hence is electrically connected to it. The P-well 16 is normally at ground potential, and so therefore is the layer 20. This is at a lower implant depth and lower potential than the N-well collection node 14, and thus the electrons are more likely to go towards the N-well 14' and be collected. For example, electron e7 in Figure 4 is more likely than not to go to the N-well 14', whereas electron e7 in Figure 3 is quite likely to go to the N-well 14' and be lost.

The invention therefore provides an improved structure for image sensors combining large area pixels with low photodiode capacitance in a manner simple to fabricate.

## Claims

1. A semiconductor structure for a solid state image sensor, comprising:
a substrate (12) of a first conductivity type;
an epitaxial layer (10) formed on one face of the substrate (12);
an array of pixels formed in the epitaxial layer (10);
each pixel having a potential well (14') of a second conductivity type formed within the epitaxial layer (10) to act as a photodiode collection node (14'), and one or more pixel active elements comprising N or P wells (16) within the epitaxial layer (10);
and in which said active element wells (16) are spaced away from the photodiode wells (14') such that the photodiode well (14') is surrounded on all its sides and at its rear by epitaxial material;
the surface of the epitaxial layer (10) around the photodiode (14') is covered by a cover layer (20) substantially thinner than said wells (14', 16) **characterised in that** said epitaxial layer (20) is grounded and provided, except for a narrow zone, around the photodiode.

2. The structure of claim 1, in which the first conductivity type is P and the second conductivity type is N; and the epitaxial layer (10) is P-epitaxial.

3. The structure of claim 1 or claim 2, in which the photodiode (14') is small in relation to the area of the pixel.

4. The structure of claim 3, in which the pixel has a width of 40-60 microns and the photodiode has a width of 3-10 microns.

5. The structure of any preceding claim in which the epitaxial layer (10) has a depth of 4-10 microns.

6. The structure of claim 5, for use with visible wavelengths, in which the epitaxial layer (10) has a depth of 4-5 microns.

7. A solid state image sensor comprising a structure in accordance with any preceding claim and image processing circuitry formed on a single chip.

## Patentansprüche

1. Eine Halbleiterstruktur für einen integrierten Bildsensor, die Folgendes beinhaltet:
ein Substrat (12) eines ersten Leitfähigkeitstyps;
eine Epitaxieschicht (10), die auf einer Fläche des Substrats (12) gebildet ist;
eine Matrix von Pixeln, die in der Epitaxieschicht (10) gebildet ist;
wobei jedes Pixel eine Potentialmulde (14') eines zweiten Leitfähigkeitstyps, die innerhalb der Epitaxieschicht (10) gebildet ist, um als Photodiodensammelknoten (14') zu wirken, und ein oder mehrere aktive Pixelelemente, die innerhalb der Epitaxieschicht (10) N- oder P-Mulden (16) beinhalten, aufweist;
und in dem die aktiven Elementmulden (16) so von den Photodiodenmulden (14') mit Abstand angeordnet sind, dass die Photodiodenmulde (14') an allen ihren Seiten und an ihrer Hinterseite von Epitaxiematerial umgeben ist;
die Oberfläche der Epitaxieschicht (10) um die Photodiode (14') herum von einer Deckschicht (20) bedeckt ist, welche im Wesentlichen dünner als die Mulden (14', 16) ist, **dadurch gekennzeichnet, dass** die Deckschicht (20) geerdet ist und, mit Ausnahme einer schmalen Zone, um die Photodiode herum bereitgestellt ist.

2. Struktur gemäß Anspruch 1, bei der der erste Leitfähigkeitstyp P und der zweite Leitfähigkeitstyp N ist; und die Epitaxieschicht (10) P-epitaxisch ist.

3. Struktur gemäß Anspruch 1 oder Anspruch 2, bei der die Photodiode (14') hinsichtlich der Pixelfläche klein ist.

4. Struktur gemäß Anspruch 3, bei der das Pixel eine Breite von 40-60 Mikrometer und die Photodiode eine Breite von 3-10 Mikrometer aufweist.

5. Struktur gemäß einem der vorhergehenden Ansprüche, bei der die Epitaxieschicht (10) eine Tiefe von 4-10 Mikrometer aufweist.

6. Struktur gemäß Anspruch 5 zur Verwendung mit sichtbaren Wellenlängen, bei der die Epitaxieschicht (10) eine Tiefe von 4-5 Mikrometer aufweist.

7. Ein integrierter Bildsensor, der eine Struktur gemäß einem der vorhergehenden Ansprüche und einen auf einem einzelnen Chip gebildeten Bildverarbeitungsschaltkreis beinhaltet.

## Revendications

1. Une structure de semi-conducteur pour un capteur d'image à l'état solide, comportant :
un substrat (12) d'un premier type de conductivité ;
une couche épitaxiale (10) formée sur une face du substrat (12) ;
une matrice de pixels formée dans la couche épitaxiale (10) ;
chaque pixel ayant un puits de potentiel (14') d'un deuxième type de conductivité formé au sein de la couche épitaxiale (10) pour faire office de noeud de collection de photodiode (14'), et un ou plusieurs éléments actifs de pixel comportant des puits N ou P (16) au sein de la couche épitaxiale (10) ;
et dans laquelle lesdits puits d'éléments actifs (16) sont espacés des puits de photodiode (14') de sorte que le puits de photodiode (14') soit entouré de tous les côtés et à l'arrière par de la matière épitaxiale ;
la surface de la couche épitaxiale (10) autour de la photodiode (14') est couverte d'une couche de fermeture (20) substantiellement plus fine que lesdits puits (14', 16) **caractérisée en ce que** ladite couche de fermeture (20) est mise à la terre et fournie autour de la photodiode, à l'exception d'une zone étroite.

2. La structure de la revendication 1, dans laquelle le premier type de conductivité est P et le deuxième type de conductivité est N ; et la couche épitaxiale (10) est P-épitaxiale.

3. La structure de la revendication 1 ou la revendication 2, dans laquelle la photodiode (14') est petite relativement à la zone du pixel.

4. La structure de la revendication 3, dans laquelle le pixel a une largeur de 40 à 60 microns et la photodiode a une largeur de 3 à 10 microns.

5. La structure de n'importe quelle revendication précédente dans laquelle la couche épitaxiale (10) a une profondeur de 4 à 10 microns.

6. La structure de la revendication 5, destinée à être utilisée avec des longueurs d'onde visibles, dans laquelle la couche épitaxlale (10) a une profondeur de 4 à 5 microns.

7. Un capteur d'image à l'état solide comportant une structure conformément à n'importe quelle revendication précédente et une circuiterie de traitement d'image formée sur une puce unique.
